# EUROPÄISCHE PATENTANMELDUNG

(11) **EP 2 604 984 A2**
(43) Veröffentlichungstag der Anmeldung: **19.06.2013**
(21) Anmeldenummer: 12007707.8
(22) Anmeldetag: 14.11.2012
(51) Int. Cl.: G01F 1/716

(54) **Magnetbaugruppe für ein Kernmagnetisches Durchflussmessgerät**

(30) Priorität: 21.11.2011 DE 102011118923
(71) Anmelder: Krohne AG, 4019 Basel (CH)
(72) Erfinder: Pors, Jan Teunis Aart, 3262 EK Oud-Beijerland (NL); Ramondt, Jan-Willem, 4817 KL Breda (NL); Spithoven, Johannes Antonius, 5521 EE Eersel (NL)
(74) Vertreter: Gesthuysen Patent- und Rechtsanwälte

(57) **Zusammenfassung**

Beschrieben und dargestellt ist eine Magnetbaugroppe (1) für ein kernmagnetisches Durchflussmessgerät mit einer zumindest einen Permanentmagneten (2) als Komponente umfassenden Anordnung.

Die erfindungsgemäße Magnetbaugruppe, deren Einbringen in die Magnetaufnahmen der Magnetisierungsvorrichtung des Durchflussmessgeräts vereinfacht ist und die insbesondere Abplatzungen von Magnetmaterial an den Permanentmagneten verhindert, ist dadurch gekennzeichnet, dass die Anordnung (3) mit einer Ummantelung (4) zum Schutz der Permanentmagnete (2) vor Abplatzungen von Magnetmaterial durch mechanische Belastungen, insbesondere beim Einbringen der Magnetbaugruppe (1) in die Magnetaufnahmen des Durchflussmessgeräts, und/oder zum vereinfachten Einbringen der Permanentmagnete (2) in die Magnetaufnahmen durch reduzierte Reibung zwischen der Magnetbaugruppe (1) und den Magnetaufnahmen und/oder zur Beeinflussung des von den Permanentmagneten (2) erzeugten Magnetfelds.

## Beschreibung

Die Erfindung betrifft eine Magnetbaugruppe für ein kernmagnetisches Durchflussmessgerät mit einer zumindest einen Permanentmagneten als Komponente umfassenden Anordnung.

Kernmagnetische Durchflussmessgeräte bestimmen den Durchfluss der einzelnen Phasen eines mehrphasigen Fluids, die Strömungsgeschwindigkeiten der einzelnen Phasen und die relativen Anteile der einzelnen Phasen im mehrphasigen Fluid in einem Messrohr durch Messung und Auswertung der von der kernmagnetischen Resonanz des mehrphasigen Fluids in einen geeigneten Sensor induzierten Spannung. Das Messprinzip der kernmagnetischen Resonanz, im Englischen wird kernmagnetische Resonanz als Nuclear Magnetic Resonance bezeichnet, beruht auf der Eigenschaft von Atomkernen mit einem freien magnetischen Moment, dem Kernspin, in Anwesenheit eines Magnetfeldes zu präzedieren. Die Präzession des das magnetische Moment eines Atomkerns repräsentierenden Vektors erfolgt dabei um den das Magnetfeld an der Stelle des Atomkerns repräsentierenden Vektor, wobei die Präzession eine Spannung in den Sensor induziert. Die Frequenz der Präzession wird als Larmorfrequenz *ω*_{L} bezeichnet und berechnet sich gemäß ω_{L} = γ *B*, wobei γ das gyromagnetische Verhältnis und *B* der Betrag der Magnetfeldstärke ist. Das gyromagnetische Verhältnis γ ist für Wasserstoffkerne maximal; insbesondere deshalb sind Fluide mit Wasserstoffkernen für kernmagnetische Durchflussmessgeräte geeignet,

Aus Ölquellen wird ein mehrphasiges Fluid, bestehend im Wesentlichen aus Rohöl, Erdgas und Salzwasser, gefördert. Sogenannte Testseparatoren zweigen einen Teil des geförderten Fluids ab, trennen die einzelnen Phasen des Fluids voneinander und bestimmen die Anteile der einzelnen Phasen in dem Fluid. Testseparatoren sind kostenintensiv, können nicht unterseeisch installiert werden und erlauben keine zeitnahen Messungen. Insbesondere sind Testseparatoren nicht im Stande, Rohölanteile kleiner als 5 % zuverlässig zu messen. Da der Rohölanteil einer jeden Quelle stetig absinkt und der Rohölanteil einer Vielzahl von Quellen bereits geringer als 5 % ist, ist es derzeit nicht möglich, diese Quellen wirtschaftlich sinnvoll auszubeuten,

Sowohl Rohöl als auch Erdgas und Salzwasser enthalten Wasserstoffkerne, für welche - wie bereits erwähnt - das gyromagnetische Verhältnis γ maximal ist. Kernmagnetische Durchflussmessgeräte sind daher besonders für den Einsatz an Ölquellen, auch unterseeisch unmittelbar an der Quelle am Meeresgrund, geeignet, aber nicht auf diese Anwendung beschränkt. Andere Anwendungen eröffnen sich beispielsweise in der petrochemischen oder in der chemischen Industrie. Ein Abzweigen eines Teils des Fluids ist nicht erforderlich, vielmehr wird das gesamte Fluid zeitnah gemessen. Im Vergleich zu Testseparatoren sind kernmagnetische Durchflussmessgeräte kostengünstiger und wartungsärmer und können insbesondere auch Rohölanteile geringer als 5 % im Fluid zuverlässig messen, wodurch die - weitere - Ausbeutung einer Vielzahl von Ölquellen erst möglich wird,

Bekannt ist aus der amerikanischen Offenlegungsschrift 2008/0174309 eine Magnetisierungsvorrichtung aus einem einen hohlzylinderförmigen Permanentmagneten bildenden Stapel von Scheibenmagneten, wobei das Magnetfeld im zylinderförmigen Innenraum der Magnetisierungsvorrichtung homogen ist, der Stapel eine Mehrzahl von Scheibenmagneten umfasst und die Scheibenmagnete durch Schrauben aus einem nichtmagnetischen Material fixiert sind. Zu jedern der Scheibenmagnete gehört eine Mehrzahl von Magnetbaugruppen, wobei jede der Magnetbaugruppen aus einem rechteckigen Stabmagneten besteht, die Magnetbaugruppen zwischen jeweils zwei Scheiben aus einem nichtmagnetischen Material in als formschlüssige Vertiefungen ausgebildeten Magnetaufnahmen eingebracht und durch Schrauben aus einem nichtmagnetischen Material fixiert sind.

Da für in den Sensor durch die Präzession der im Fluid enthaltenen Wasserstoffatome hohe induzierte Spannungen ein starkes Magnetfeld benötigt wird, kommen entsprechend starke Magnetbaugruppen zum Einsatz. Aufgrund der Mehrzahl von räumlich eng zueinander angeordneten Magnetbaugruppen in jeder der Scheibenmagnete, kommt es durch die Wechselwirkung der Magnetfelder der einzelnen Magnetbaugruppen zu beträchtlichen Kraftwirkungen der Magnetbaugruppen untereinander. Diese Kraftwirkungen erschweren das Einbringen der einzelnen Magnetbaugruppen erheblich, und vielfach kommt es beim Einbringen unter besagten Kraftwirkungen durch ungünstigen Kontakt der Magnetbaugruppen mit den Magnetaufnahmen zu Abplatzungen von Magnetmaterial, da dieses spröde ist. Durch das Abplatzen von Magnetmaterial wird das Magnetfeld einer Magnetbaugruppe verändert und damit auch die Homogenität des resultierenden Magnetfelds im Innenraum der Magnetisierungsvorrichtung negativ beeinflusst. Da die von der Präzession der Atomkerne in den Sensor induzierte Spannung von der Larmorfrequenz und diese von der Magnetfeldstärke abhängt, haben Abplatzungen von Magnetmaterial eine Verschlechterung der Messqualität zur Folge.

Aufgabe der vorliegenden Erfindung ist die Angabe einer Magnetbaugruppe, deren Einbringen in die Magnetaufnahmen der Magnetisierungsvorrichtung des Durchflussmessgeräts vereinfacht ist und die insbesondere Abplatzungen von Magnetmaterial an den Permanentmagneten verhindert.

Die erfindungsgemäße Magnetbaugruppe, bei der die zuvor hergeleitete und aufgezeigte Aufgabe gelöst ist, ist zunächst und im Wesentlichen dadurch gekennzeichnet, dass die Anordnung mit einer Ummantelung zum Schutz der Permanentmagnete vor Abplatzungen von Magnetmaterial durch mechanische Belastungen, insbesondere beim Einbringen der Magnetbaugruppe in die Magnetaufnahmen des Durchflussmessgeräts, und/oder zum vereinfachten Einbringen der Permanentmagnete in die Magnetaufnahmen durch reduzierte Reibung zwischen der Magnetbaugruppe und den Magnetaufnahmen und/oder zur Beeinflussung des von den Permanentmagneten erzeugten Magnetfelds realisiert ist.

Die Ummantelung der zumindest einen Permanentmagneten umfassenden Magnetbaugruppe ist wenigstens an den Kontaktstellen zwischen den Permanentmagneten und der Magnetaufnahme vorzusehen. Das Material der Ummantelung ist dabei unter dem Gesichtpunkt zu wählen, Abplatzungen von Magnetmaterial bei Kontakt der Magnetbaugruppe mit der Magnetaufnahme und auch schon zuvor bei der Handhabung der Magnetbaugruppe zu verhindern. In Frage kommen dafür als Materialien beispielsweise zähelastische Kunststoffe oder auch Metalle mit unter anderen einer geringen Sprödigkeit und insbesondere einer geringeren Sprödigkeit als die des Magnetmaterials.

Überraschenderweise ist das Einbringen der erfindungsgemäßen Magnetbaugruppe in die Magnetaufnahmen einfacher als das einer aus dem Stand der Technik bekannten Magnetbaugruppe. Daher wurde in weiteren Versuchen die Materialpaarung zwischen der Ummantelung und den Magnetaufnahmen mit dem Ziel einer möglichst geringen Reibung optimiert. Im Rahmen der Versuche zeigte sich unerwartet, dass das resultierende Magnetfeld der erfindungsgemäßen Magnetbaugruppe durch die magnetische Leitfähigkeit des Materials der Ummantelung der Permanentmagneten vorteilhaft beeinflusst werden kann. Beispielsweise kann die Ummantelung im Bereich der Pole der Permanentmagneten aus einem Material mit hoher magnetischer Leitfähigkeit als eine Art magnetische Linse fungieren und das Magnetfeld formen.

Bei einer bevorzugten Ausführungsform der erfindungsgemäßen Magnetbaugruppe umfasst die Anordnung neben zumindest einem Permanentmagneten als Komponente auch wenigstens einen Abstandhalter als Komponente. Oftmals weisen alle Permanentmagnete die gleichen räumlichen Abmessungen auf, wodurch Kosten reduziert und der Aufbau der Magnetbaugruppe vereinfacht wird. Vielfach werden Abstandhalter zwischen Permanentmagnete angeordnet, um das resultierende Magnetfeld zu formen. Die Formung des resultierenden Magnetfelds kann dabei nicht nur durch die geometrische Ausformung der Abstandhalter, sondern auch durch die Wahl des Materials der Abstandhalter im Hinblick auf die Permeabilität erfolgen.

Bei einer weiteren bevorzugten Ausführungsform der erfindungsgemäßen Magnetbaugruppe stehen wenigstens zwei der Komponenten - die Komponenten sind die Permanentmagnete und die Abstandhalter einer Anordnung - in Kontakt. Vorzugsweise sind dabei die in Kontakt stehenden Bereiche der Oberflächen der Komponenten ebene Flächen. Insbesondere können die in Kontakt stehenden ebenen Flächen der Komponenten deckungsgleich sein und vorzugsweise zusätzlich deckungsgleich angeordnet sein. Die derart ausgestaltete Magnetbaugruppe ist monolithisch und erlaubt dadurch ein hohes Maß an Freiheitsgraden bei der Ausgestaltung des resultierenden Magnetfelds. Zusätzlich können die in Kontakt stehenden Bereiche der Oberflächen auch miteinander verbunden werden, beispielsweise stoffschlüssig verbunden werden. Durch die Verbindung wird die Anordnung mechanisch robust fixiert und die Handhabung vereinfacht.

Bei einer ganz besonders bevorzugten Ausführungsform der erfindungsgemäßen Magnetbaugruppe sind mehrere der Komponenten, deren ebene und deckungsgleiche Flächen deckungsgleich in Kontakt stehen, derart angeordnet, dass sich eine stabförmige Anordnung ergibt, und sind die einzelnen Komponenten derart ausgebildet, dass zur Stablängsachse senkrechten äußeren Querschnittkonturen der Komponenten entlang der Stablängsachse konstant und gleich sind. Insbesondere kann die zur Stablängsachse äußere Querschnittkontur der stabförmigen Anordnung rotationsunsymmetrisch bezüglich der Stablängsachse sein und vorzugsweise rechteckig sein. Die rotationsunsymmetrische Querschnittkontur ermöglicht die formschlüssige Anordnung der stabförmigen Magnetbaugruppe in den Magnetaufnahmen der Magnetisierungsvorrichtung in der Art, dass ein Drehen der Magnetbaugruppe um die Längsachse der Magnetbaugruppe nicht möglich ist, Eine Drehbarkeit der Magnetbaugruppe würde die Homogenität im Innenraum der Magnetisierungsvorrichtung des Magnetfelds beeinträchtigen.

Bei einer weiteren vorteilhaften Ausführungsform der erfindungsgemäßen Magnetbaugruppe besteht die Ummantelung aus wenigstens einem auf wenigstens einer der äußeren Flächen der Anordnung angeordneten Streifen. Insbesondere können bei einer stabförmigen Anordnung der Komponenten die Streifen längs der Stablängsachse angeordnet sein, wodurch der Installationsaufwand der Ummantelung minimiert wird. Die äußeren Flächen der Anordnung ergeben sich aus der Anordnung der Komponenten. Die Streifen können beispielsweise Kunststoff- oder Metallfolien oder Metallbleche, also dickere Metallfolien, sein. Während die Kunststofffolien nur Schutz gegen Abplatzungen von Magnetmaterial bieten und ein einfaches Einbringen der Magnetbaugruppe in die Magnetaufnahme ermöglichen, ermöglichen die Metallfolien bzw. die Metallbleche aufgrund der magnetischen Leitfähigkeit des ausgewählten Materials auch eine Beeinflussung des resultierenden Magnetfelds,

Bei einer ganz besonders bevorzugten Ausführungsform der erfindungsgemäßen Magnetbaugruppe sind die Komponenten zueinander durch die formschlüssig angeordneten Streifen fixiert. Die Möglichkeit, die Komponenten durch die als Ummantelung dienenden Streifen mechanisch ausreichend stabil zueinander zu fixieren, ergab sich überraschend während der Untersuchungen zu den Auswirkungen des Streifenmaterials auf das resultierende Magnetfeld. Die Streifen übernehmen damit, neben ihrer Funktion als Schutz vor Abplatzungen von Magnetmaterial und der Reduktion der Reibung beim Einbringen der Magnetbaugruppe in eine der Magnetaufnahmen, eine dritte Funktionalität. Durch die Möglichkeit, mehrere Komponenten durch Streifen auf einfache Weise mechanisch zueinander zu fixieren, ist es nun möglich, die Permanentmagnete und die Abstandhalter einer Anordnung auf einfache Weise zu konfektionieren und die Magnetbaugruppe in einem Arbeitsgang in eine der Magnetaufnahmen einzubringen. Dadurch wird der Herstellungsaufwand einer Magnetisierungsvorrichtung deutlich reduziert. Alternativ oder zusätzlich kann wenigstens einer der Streifen mit wenigstens einer der Komponenten verbunden werden, vorzugsweise stoffschlüssig verbunden werden.

Bei einer weiteren bevorzugten Ausführungsform der erfindungsgemäßen Magnetbaugruppe ist die Ummantelung ein Rohr, in das die stabförmige Anordnung eingebracht wird. Das Rohr ist seinerseits dann in einer der Magnetaufnahmen angeordnet und kann insbesondere in der Magnetaufnahme drehbar angeordnet und gegen Drehbewegungen fixierbad sein. Für gewöhnlich ist das Rohr aus einem nichtmagnetischen Material hergestellt, um eine weitere Beeinflussung des Magnetfelds zu vermeiden. Durch die Drehbarkeit des Rohres in der Magnetaufnahme ist es möglich, das resultierende Magnetfeld im Innenraum des zylinderförmigen Permanentmagneten zu beeinflussen. Vorzugsweise ist die zur Rohrlängsachse senkrechte innere Querschnittkontur derart an die zur Stablängsachse senkrechte äußere Querschnittkontur angepasst, so dass ein Drehen relativ zum Rohr der in das Rohr eingebrachten Anordnung um die Rohrlängsachse ausgeschlossen ist. Sind die Magnete im Rohr und/oder das Rohr in der Magnetaufnahme nicht spielfrei angeordnet, so wird die Homogenität des Magnetfelds im Innern des zylinderförmigen Permanentmagneten beeinträchtigt.

Im Einzelnen gibt es nun verschiedene Möglichkeiten, die erfindungsgemäße Magnetbaugruppe auszugestalten und weiterzubilden. Dazu wird verwiesen auf die dem Patentanspruch 1 nachgeordneten Patentansprüche und auf die Beschreibung bevorzugter Ausführungsbeispiele in Verbindung mit der Zeichnung. In der Zeichnung eines Ausführungsbeispiels der erfindungsgemäßen Magnetbaugruppe zeigen
- Fig. 1: in einer Explosionsdarstellung eine bevorzugte Ausführungsform einer erfindungsgemäßen Magnetbaugruppe,
- Fig. 2: die Magnetbaugruppe nach Fig. 1 mit noch nicht umgebördelten Laschen und
- Fig. 3: die Magnetbaugruppe nach Fig. 1, nunmehr mit umgebördelten Laschen.

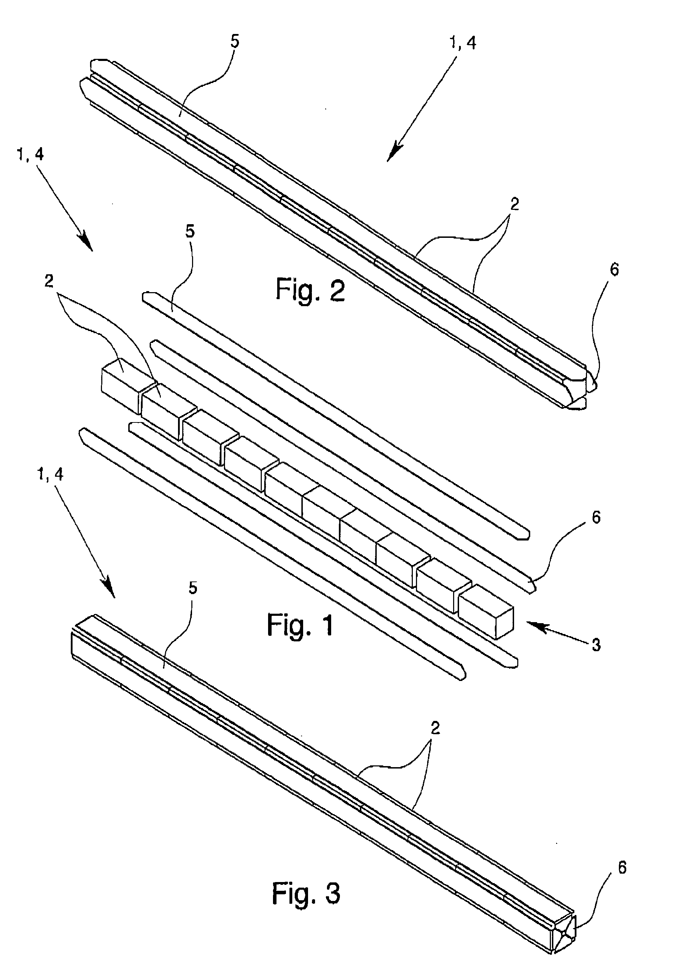

Die Magnetbaugruppe 1 besteht, wie in der Explosionsdarstellung in Fig. 1 besonders gut zu erkennen ist, aus zehn Permanentmagneten 2, die eine Anordnung 3 bilden, und aus vier eine Ummantelung 4 bildenden länglichen Messingblechstreifen. Alle Permanentmagnete 2 sind quaderförmig ausgebildet und derart angeordnet, dass die in Kontakt stehenden ebenen Flächen der Permanentmagnete 2 deckungsgleich und deckungsgleich angeordnet sind, so dass sich eine Stabanordnung 3 ergibt Folglich ist die zur Stablängsachse senkrechte äußere Querschnittkontur der Stabanordnung 3 rechteckig und konstant entlang der Stablängsachse. Die in Kontakt stehenden Flächen der Permanentmagnete 2 liegen aneinander an, sind aber nicht stoffschlüssig miteinander verbunden.

Fig. 2 zeigt die Anordnung von vier die Ummantelung 4 bildenden Messingblechstreifen 5 auf den vier freien Flächen der Stabanordnung 3 längs der Stablängsachse. Die Messingblechstreifen 5 liegen auf den Flächen formschlüssig auf, sind mit diesen aber nicht verbunden. Durch die Wahl von Messing als Material für die Streifen wird das resultierende Magnetfeld nicht beeinflusst. Die Messingblechstreifen 5 sind länger als die Stabanordnung 3, und die dreieckigen, über die Stabanordnung 3 überstehenden Enden der Messingblechstreifen 5 bilden Laschen 6.

Fig. 3 zeigt die Magnetbaugruppe 1 im einbaufertigen Zustand mit umgebördelten Laschen 6. Durch das formschlüssige Umbördeln der Laschen 6 auf den Stirnseiten der Permanentmagnete 2 an den Enden der Stabanordnung 3 werden die Permanentmagnete 2 der Stabanordnung 3 mechanisch zueinander fixiert. Die Länge der Messingblechstreifen 5 und die Form der Enden der Messingblechstreifen 5 sind gerade so gewählt, dass sich die umgebördelten Laschen 6 nicht gegenseitig berühren. Durch die Messingblechstreifen 5 bleibt die Querschnittfläche der Magnetbaugruppe 1 rotationsunsymmetrisch, so dass ein Drehen der Magnetbaugruppe 1 in den Magnetaufnahmen einer Magnetisierungsvorrichtung um die Längsachse der Magnetbaugruppe 1 unterbunden ist.

Die als Ummantelung 4 dienenden Messingblechstreifen 5 erfüllen drei Aufgaben. Als erstes schützen sie das spröde Magnetmaterial der Permanentmagnete 2 vor Abplatzungen durch mechanische Belastungen sowohl bei der allgemeinen Handhabung als auch beim Einbringen in die Magnetaufnahmen. Als zweites vereinfachen sie das Einbringen, da zum einen die Reibung zwischen den Messingbleichstreifen 5 und den Magnetaufnahmen geringer ist als die Reibung zwischen dem Magnetmaterial und den Magnetaufnahmen und da zum anderen zehn Permanentmagnete 2 in einem Vorgang eingebracht werden können, - anstelle von einem Permanentmagneten. Als drittes fixieren die Messingblechstreifen 5 auf einfache und kostensgünstige Weise die Permanentmagnete 2 der Stabanordnung 3.

## Patentansprüche

1. Magnetbaugruppe für ein kernmagnetisches Durchflussmessgerät mit einer zumindest einen Permanentmagneten als Komponente umfassenden Anordnung,
**dadurch gekennzeichnet,**
**dass** die Anordnung (3) mit einer Ummantelung (4) zum Schutz der Permanentmagnete (2) vor Abplatzungen von Magnetmaterial durch mechanische Belastungen, insbesondere beim Einbringen der Magnetbaugruppe (1) in die Magnetaufnahmen des Durchflussmessgeräts, und/oder zum vereinfachten Einbringen der Permanentmagnete (2) in die Magnetaufnahmen durch reduzierte Reibung zwischen der Magnetbaugruppe (1) und den Magnetaufnahmen und/oder zur Beeinflussung des von den Permanentmagneten (2) erzeugten Magnetfelds.

2. Magnetbaugruppe nach Anspruch 1, **dadurch gekennzeichnet dass** zu der Anordnung (3) wenigstens ein Abstandhalter als Komponente gehört.

3. Magnetbaugruppe nach Anspruch 1 oder 2, **dadurch gekennzeichnet, dass** wenigstens zwei der Komponenten miteinander in Kontakt stehen,

4. Magnetbaugruppe nach Anspruch 3, **dadurch gekennzeichnet, dass** die in Kontakt stehenden Bereiche der Oberflächen der Komponenten ebene Flächen sind.

5. Magnetbaugruppe nach Anspruch 4, **dadurch gekennzeichnet, dass** die in Kontakt stehenden ebenen Flächen der Komponenten deckungsgleich sind und vorzugsweise deckungsgleich angeordnet sind.

6. Magnetbaugruppe nach Anspruch 5, **dadurch gekennzeichnet, dass** mehrere der Komponenten derart angeordnet sind, dass sich eine stabförmige Anordnung (3) ergibt, und dass die einzelnen Komponenten derart ausgebildet sind, dass die zur Stablängsachse senkrechten äußeren Querschnittkonturen der Komponenten entlang der Stablängsachse konstant und gleich sind.

7. Magnetbaugruppe nach Anspruch 6, **dadurch gekennzeichnet, dass** die zur Stablängsachse äußere Querschnittkontur der stabförmigen Anordnung (3) rotationsunsymmetrisch bezüglich der Stablängsachse ist und vorzugsweise rechteckig ist.

8. Magnetbaugruppe nach einem der Ansprüche 1 bis 7, **dadurch gekennzeichnet, dass** die Ummantelung aus wenigstens einem auf wenigstens einer der äußeren Flächen der Anordnung (3) angeordneten Streifen besteht, vorzugsweise einem Messingblechstreifen (5),

9. Magnetbaugruppe nach Anspruch 6 oder 7 und nach Anspruch 8, **dadurch gekennzeichnet, dass** die Streifen längs der Stablängsachse angeordnet sind.

10. Magnetbaugruppe nach Anspruch 8 oder 9, **dadurch gekennzeichnet, dass** die Komponenten durch die Streifen zueinander fixiert sind.

11. Magnetbaugruppe nach einem der Ansprüche 8 bis 10, **dadurch gekennzeichnet, dass** wenigstens einer der Streifen mit wenigstens einer der Komponenten verbunden ist, vorzugsweise stoffschlüssig verbunden ist.

12. Magnetbaugruppe nach Anspruch 6 oder 7, **dadurch gekennzeichnet, dass** die Ummantelung (4) ein Rohr ist, insbesondere ein in der Magnetaufnahme drehbar angeordnetes und gegen Drehbewegungen fixiertes Rohr ist.

13. Magnetbaugruppe nach Anspruch 7 und 12, **dadurch gekennzeichnet, dass** die zur Rohrlängsachse senkrechte innere Querschnittkontur derart an die zur Stablängsachse senkrechte äußere Querschnittkontur angepasst ist, dass ein Drehen relativ zur Ummantelung (4) der in die Ummantelung (4) eingebrachten Anordnung (3) um die Rohrlängsachse ausgeschlossen ist.

14. Magnetbaugruppe nach einem der Ansprüche 1 bis 13, **dadurch gekennzeichnet, dass** wenigstens zwei der Komponenten miteinander verbunden sind, insbesondere stoffschlüssig miteinander verbunden sind.

15. Magnetbaugruppe nach einem der Ansprüche 1 bis 14, **dadurch gekennzeichnet, dass** die Permanentmagnete (2) die gleichen räumlichen Abmessungen aufweisen.
